# EUROPEAN PATENT APPLICATION

(11) **EP 4 626 211 A1**
(43) Date of publication of application: **01.10.2025**
(21) Application number: 24472006.6
(22) Date of filing: 29.03.2024
(51) Int. Cl.: H10N 52/01, H10N 59/00

(54) **REDUCED NOISE HALL SENSOR**

(71) Applicant: Melexis Bulgaria EOOD, 1138 Sofia (BG)
(72) Inventor: Op De Beeck, Jonathan, 3980 Tessenderlo (BE); Van Haver, Maxime, 3980 Tessenderlo (BE)
(74) Representative: Winger

(57) **Abstract**

A semiconductor chip (100) comprising at least one Hall sensor (110). The at least one Hall sensor (110) comprises: an electrically conductive well (111) with a first conductivity type in a semiconductor substrate; a plurality of well contacts (114) arranged at a surface of the electrically conductive well (111), and having the first conductivity type; a plurality of shallow trench isolation regions (113) which are delimiting the well contacts (114) at the surface of the electrically conductive well (111). An implant (112) of a second conductivity type, opposite to the first conductivity type, is present on sides of the shallow trench isolation regions (113) such that the Hall sensor (110) comprises a depletion region comprising: a first subregion (115a) between the implant (112) and the electrically conductive well (111), and a second subregion (115b) between the implant (112) and the well contact (114).

## Description

### Field of the invention

The invention relates to the field of Hall sensors. More specifically it relates to Hall sensors which are manufactured as an integrated circuit and are embedded in a semiconductor chip.

### Background of the invention

Hall sensors are magnetic field sensors which are based on the Hall effect and provide an electrical output signal which is indicative for a predetermined component of a magnetic field. Three-dimensional Hall sensors allow to determine the strength and the direction of the magnetic field.

Semiconductor Hall sensors may be designed as horizontal Hall sensors or as vertical Hall sensors. The Hall element of the sensor is realized with an electrically conductive well, formed on a semiconductor substrate. Semiconductor Hall sensors are embedded in a semiconductor substrate by providing well contacts in an electrically conductive well. The well contacts provide the needed electrical connections for a Hall sensor for applying the bias voltages and forming sensor readout contacts. A horizontal Hall sensor has 4 or more well contacts and a vertical Hall sensor has 3 or more well contacts (see for example US8922207B2).

The well contacts are formed by creating regions on the electrically conductive well with higher doping concentration than the doping of the well and using the same type of conductivity, n or p. However, the implementation of the well contacts brings non-symmetry between the well contacts and thereby to the Hall sensor and therefore decreases the efficiency of current spinning when current spinning technique is used for offset cancellation. In order to achieve low offset in a Hall sensor, then also the symmetry of the device is key for good result.

There is therefore a need for Hall sensors with an increased symmetry between the well contacts.

### Summary of the invention

It is an object of embodiments of the present invention to provide a Hall sensor with an increased symmetry between the well contacts. It is, furthermore, an object of embodiments of the present invention to provide a method for providing such a Hall sensor.

The above objective is accomplished by a method and device according to the present invention.

In a first aspect embodiments of the present invention relate to a semiconductor chip comprising at least one Hall sensor. The at least one Hall sensor comprises:
- an electrically conductive well with a first conductivity type in a semiconductor substrate,
- a plurality of well contacts arranged at a surface of the electrically conductive well, and having the first conductivity type,
- a plurality of shallow trench isolation regions which are delimiting the well contacts at the surface of the electrically conductive well,
- an implant of a second conductivity type, opposite to the first conductivity type, is present on sides of the shallow trench isolation regions such that the Hall sensor comprises a depletion region comprising:
- a first subregion between the implant on the sides of the shallow trench isolation regions and the electrically conductive well, and
- a second subregion between the implant on the sides of the shallow trench isolation regions and the well contact.

In embodiments of the present invention the first conductivity type may be n-type and the second conductivity type p-type.

Alternatively, in embodiments of the present invention the first conductivity type may be p-type and the second conductivity type n-type.

It is an advantage of embodiments of the present invention that the well contacts are defined by forming Shallow Trench Isolation (STI) structures next to the well contacts as this allows to obtain a Hall sensor with an increased symmetry between the well contacts. This is for example advantageous when implementing offset cancellation using current spinning. When defining the contacts by STI, this may result in an increased noise level compared to other Hall sensors for which the STI is not present because of charged trapping in the dielectric material. It is an advantage of embodiments of the present invention that, due to the presence of the depletion region comprising a first subregion between the implant on the sides of the shallow trench isolation regions and the electrically conductive well, and a second subregion between the implant on the sides of the shallow trench isolation regions and the well contact, the electron current is shielded from defects and trapped charges in STI regions in a Hall device. Thus, a reduced noise level can be obtained.
In embodiments of the present invention the implant has a thickness smaller than 5 µm.

In embodiments of the present invention the implant has a dopant concentration of at least 1e15cm-3.

In embodiments of the present invention shallow trench isolation regions have a depth of at least 100 nm.

In embodiments of the present invention the electrically conductive well has a dopant concentration of at least 1e15cm-3. In embodiments of the present invention the dopant concentration may even be higher than 1e19cm-3.

In embodiments of the present invention the well contacts have a dopant concentration of at least 1e18cm-3. In embodiments of the present invention the dopant concentration may even be higher than 1e20cm-3.

In embodiments of the present invention the semiconductor chip comprises a driver circuit for biasing a pair of the well contacts of the at least one Hall sensor and a readout circuit for reading an output signal between another pair of the well contacts of the at least one Hall sensor.

In embodiments of the present invention the semiconductor chip comprises a processor for processing the output signal and/or for controlling the driver circuit.

In embodiments of the present invention the semiconductor chip comprises at least three Hall sensors sensitive to three linear independent directions. In embodiments of the present invention combinations of horizontal and vertical Hall sensors may be used for obtaining such a semiconductor chip.

In embodiments of the present invention the at least one Hall sensor may be a horizontal Hall sensor or a vertical Hall sensor. In embodiments of the present invention the semiconductor chip may comprise a horizontal and a vertical Hall sensor.

In a second aspect embodiments of the present invention relate to a method for manufacturing a semiconductor chip in accordance with embodiments of the present invention.

The method comprises:
- providing a semiconductor substrate,
- doping the semiconductor substrate with a dopant of a first conductivity type to obtain an electrically conductive well in the semiconductor substrate,
- providing shallow trench isolation regions in the electrically conductive well,
- doping the semiconductor substrate with a dopant of a second conductivity type, opposite to the first conductivity type, to provide implants on sides of the shallow trench isolation regions,
- doping regions between the shallow trench isolation regions with a dopant with the first conductivity type,
wherein the implants are provided such that the Hall sensor comprises a depletion region which comprises a first subregion between the implant and the electrically conductive well, and a second subregion between the implant and the well contact.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a top view of a semiconductor chip comprising a Hall sensor in accordance with embodiments of the present invention.
FIG. 2 shows the cross section A-A' of the semiconductor chip in FIG. 1.
FIG. 3 shows part of the cross-section B-B' of the semiconductor chip in FIG. 1.
FIG. 4 shows a flow chart of an exemplary method in accordance with embodiments of the present invention.
FIG. 5 shows different steps to manufacture a semiconductor chip comprising a Hall sensor using an exemplary method in accordance with embodiments of the present invention.
FIG. 6 shows a block diagram of an exemplary semiconductor chip in accordance with embodiments of the present invention.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

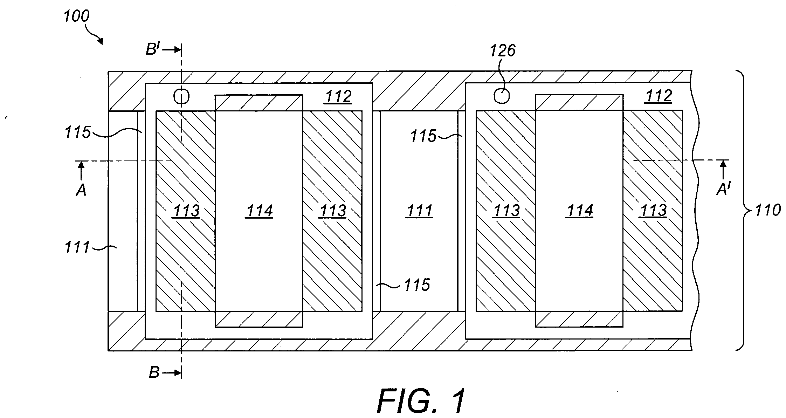

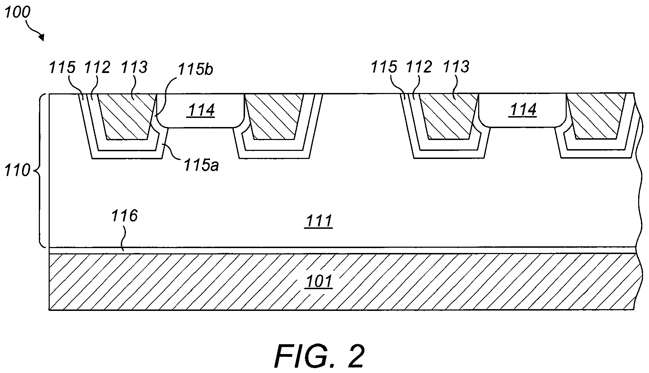

In a first aspect embodiments of the present invention relate to a semiconductor chip 100 comprising a Hall sensor 110. An example of such a semiconductor chip is illustrated in the schematic drawings of FIG. 1 and FIG. 2. FIG. 1 shows a top view of a semiconductor chip 100 comprising a Hall sensor in accordance with embodiments of the present invention. FIG. 2 shows a vertical cross-section A-A' of the same semiconductor chip as in FIG. 1.

The Hall sensor 110 in FIG. 2 is embedded in a semiconductor substrate. The semiconductor substrate may for example be a silicon substrate 101. Also, other high electron mobility materials such as gallium arsenide or indium arsenide may be used. The semiconductor substrate 101 is in this example doped with dopants of a second conductivity type. In this example the semiconductor substrate is doped with p-type dopants.

In the semiconductor substrate an electrically conductive well 111 of a first conductivity type (with e.g. n-type conductivity) is provided by doping the region with dopants of the first conductivity type. Because the well is doped with opposite dopants as the semiconductor substrate 101, a depletion layer 116 is formed between the conductive well 111 and the substrate 101. This depletion layer is not significant for the invention.

A plurality of well contacts 114, which are doped with dopants of the first conductivity type (in this example with n-type dopants), are arranged at the surface of the well 111 to provide contacts for the Hall sensor. A plurality of shallow trench isolation regions 113, which are delimiting the well contacts 114, are arranged at the surface of the well 111. The STI regions are typically filled with an oxide, e.g. CVD-oxide. However, the filling oxide causes carrier trapping which impairs the performance of the sensor. To reduce the effect of the carrier trapping, an implant region 112 of the second conductivity type is present between the sides of the shallow trench isolation regions 113 and the electrically conductive well 111 and at least partially between the STI regions and the well contact 114. In embodiments of the present invention the implant region 112 of the second conductivity type may be present between the bottom of the shallow trench isolation regions 113 and the electrically conductive well 111. Because of the implant on the sides of the STI region and optionally on the bottom of the STI region, a first depletion subregion 115a is formed between the implant region 112 of the second conductivity type and the well 111 and a second depletion subregion 115b between the implant region 112 of the second conductivity type and the well contact 114.

For each well contact 114, a shallow trench isolation region 113 is implemented, which is delimiting the well contact 114, and thereby a depletion region is formed at least partially between the well contact 114 and STI region 113. The STI region may be formed such that its sidewall is touching the well contact 114, as shown in FIG. 1. In such a case, the implant region 112 of the second conductivity type is not fully covering all the sides of the STI trench, but even then, there is a part of the sidewall which comprises the implant region 112 and therefore also the second depletion subregion 115b between the STI trench and the well contact 114.

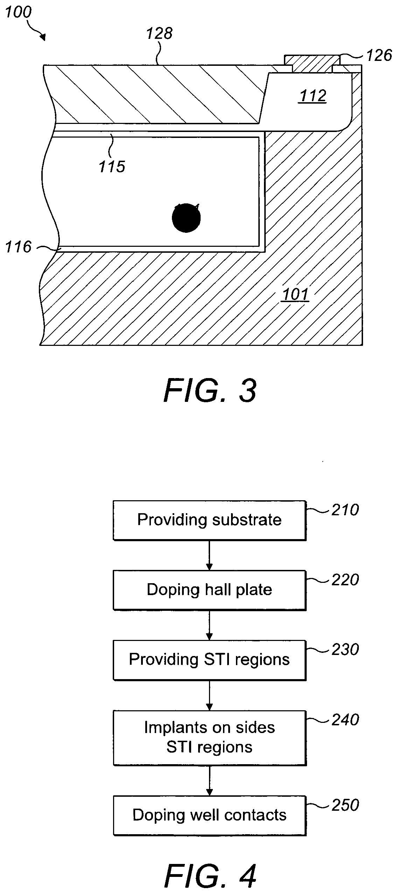

In embodiments of the present invention the implant region 112 of the second conductivity type is preferably connected to a constant voltage for its advantageous effect. In embodiments of the present invention the semiconductor chip comprises a contact 126 in contact with the implant region 112 of the second conductivity type. An example thereof is illustrated in FIG. 3 which shows a part of the cross-section B-B' of the semiconductor chip shown in FIG. 1. As illustrated in FIG. 3, the voltage can be provided through contact 126 which may for example be a metal 1 layer through an oxide layer 128, which may be formed by the oxide 113 of the trench and BEOL dielectric layer of the used process. FIG. 3 also shows the depletion region 115 between the implant region 112 and the conductive well 111 and the depletion layer 116 between the conductive well 111 and the substrate 101.

In embodiments of the present invention the Hall sensor may be a horizontal Hall sensor and/or a vertical Hall sensor. In embodiments of the present invention the semiconductor chip may comprise a plurality of Hall sensors. These may be horizontal or vertical or a combination of horizontal and vertical Hall sensors.

It is an advantage of embodiments of the present invention that a semiconductor chip is provided for sensitive and accurate magnetic field measurements based on the Hall effect. It is an advantage of embodiments of the present invention that the electron current is shielded from defects and trapped charges in STI regions in a Hall device. Thus, a Hall sensor is obtained which has a reduced noise level on the output signal, compared to a Hall sensor which does not have these regions 112 of the second conductivity type (e.g. p-type) between the sides of the shallow trench isolation regions 113 and the electrically conductive well 111. By providing the regions 112 of the second conductivity type between the sides of the shallow trench isolation regions 113 and the electrically conductive well 111 the effect of trapped charges in the STI to the noise level of the output signal is reduced. A direct contact may be present between the shallow trench isolation region 113 and the neighboring well contact 114. This is advantageous as a small device footprint may be obtained using such a configuration.

In embodiments of the present invention the p-type implant 112 of the second conductivity type may have a thickness smaller than 5 µm. The thickness is measured from the edge of the STI to the edge of the implant 112 of the second conductivity type at the side of the conductive well. In embodiments of the present invention the thickness may even be smaller than 500 nm.

In embodiments of the present invention the implant 112 may be a p-type implant 112. It may have a dopant concentration of at least 1e15cm-3. In embodiments of the present invention the dopant concentration of the p-type implant 112 may even be higher than 1e17cm-3.

In embodiments of the present invention the STI regions 113 have a depth of at least 100 nm. In embodiments of the present invention the depth of the STI may even be higher than 300 nm. The depth of the STI regions may be up to micrometers. In embodiments of the present invention the well contacts 114 have a depth which is of the same order of magnitude as the depth of the STI regions 113. In embodiments of the present invention the depth of the depth of the well contacts 114 may for example range between 30% and 100% of the depth of the STI regions 113.

In a second aspect embodiments of the present invention relate to a method for manufacturing a semiconductor chip comprising at least one Hall sensor in accordance with embodiments of the present invention. A flow chart of an exemplary method in accordance with embodiments of the present invention is shown in FIG. 4.

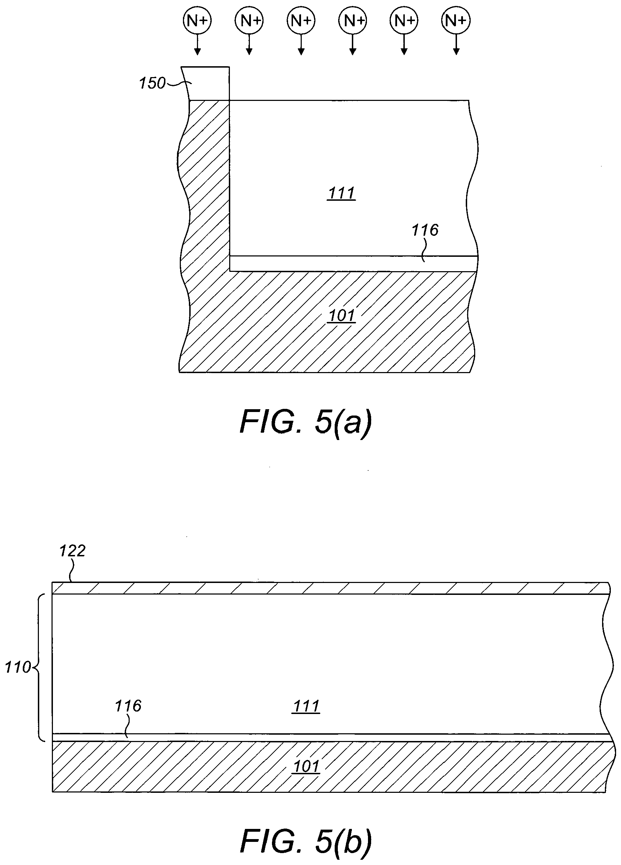

First a semiconductor substrate 101 is provided 210. The substrate may for example be bulk CMOS technology or SOI substrate. This semiconductor substrate is first doped 220 with a dopant of a first conductivity type to obtain an electrically conductive well 111 in the semiconductor substrate. This conductive well 111 is the Hall plate. A mask 150 is used for the doping. At least one Hall plate is provided. This step is shown in FIG. 5(a). FIG. 5(a) the depletion layer 116 between the conductive well 111 and the substrate 101.

After forming the at least one Hall plate, the mask 150 is removed. During stack deposition an oxide layer is formed on top of the substrate 101 and the well 111, after which a silicon nitride and photoresist layers are formed on top of the oxide layer. This is shown in FIG. 5(b), in which the layer 122 represents the three above mentioned layers combined.

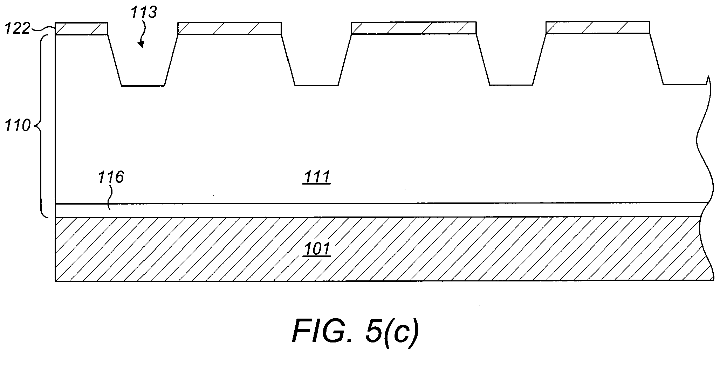

The method 200, furthermore, comprises providing 230 shallow trench isolation regions 113 in the electrically conductive well 111. The STI regions 113 may be achieved using etching, e.g. DRIE and using the layer 122 as a mask. This is shown in FIG. 5(c).

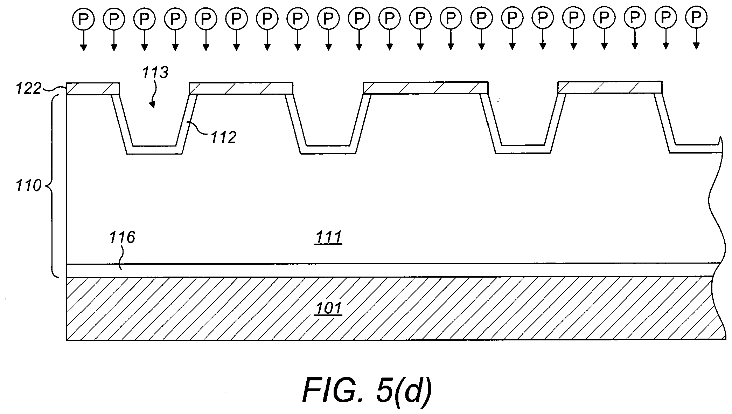

After forming the STI regions, doping 240 the semiconductor substrate is performed with a dopant of a second conductivity type, opposite to the first conductivity type, to obtain implants 112 between the shallow trench isolation regions 113 and the electrically conductive well 111 of the first conductivity type, as shown in FIG. 5(d). This may be done by using the layer 122 of the previous step as a mask or by using a different mask. In embodiments of the present invention the layer 122 may be used for other devices on the IC. In that case a separate mask is used for providing the implants 112 by doping.

In embodiments of the present invention the layer 122 may be removed after doping of the STI regions.

In embodiments of the present invention the trenches 113 are filled with oxide (e.g. CVD-oxide) and the top level is polished.

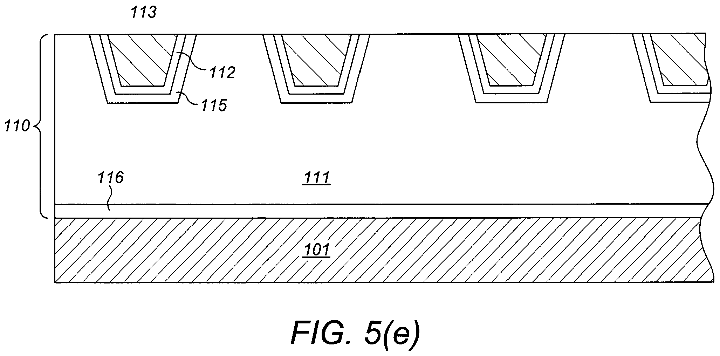

FIG. 5(e) shows the substrate 101 after these processing steps. Alternatively, the etching of the STI regions may be done after doping the well 111 with a dopant of the second conductivity type to form the implants 112. In general, the formation of STI regions is well known from modern CMOS processes.

Doping the well 111 with dopants of the second conductivity type results in a depletion region between the two doped regions. Therefore, in addition to the region 112 in FIG. 5(d), FIG. 5(e) shows the depletion region 115 between the implant 112 of the second conductivity type and the well 111 of the first conductivity type.

Depending on, e.g. doping time, doping concentration level, ion implantation energy and angle, and mask misalignment, the implant region 112 may reach the top level of the region of the first conductivity type, i.e. the top level of the substrate 101, but it also may stay below that level.

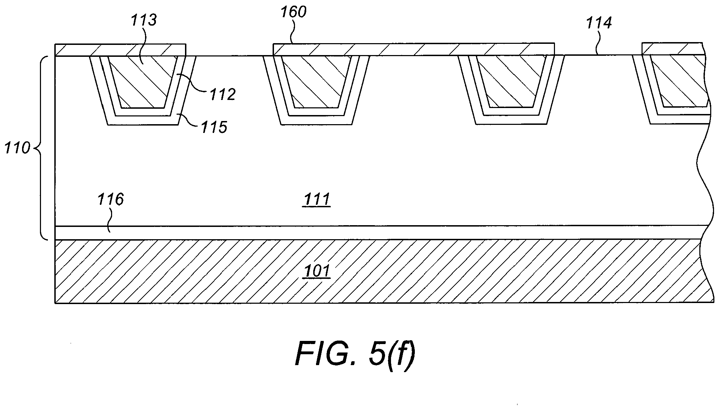

In the final step, doping 250, a plurality of well contacts 114 are formed between the STI regions 113. For that purpose, a new mask 160 is formed on the substrate and ion plantation is performed with a dopant of the first conductivity type. This results the structure shown in FIG. 5(f).

In order to contact the well contacts 114 to the readout or biasing circuitry, standard CMOS BEOL techniques may be used, i.e. providing pre-metal dielectric on the substrate before connecting the n-wells to a metal layer, e.g. metal 1 layer of the used process.

At least three well contacts should be obtained for a vertical Hall sensor and at least four well contacts should be obtained for a horizontal Hall sensor. For each implant 112 a depletion region is present between the implant and the electrically conductive well 111. This region is referred to as the first subregion 115a. A depletion region is also present between each implant 112 and its neighboring well contact 114. This region is referred to as the second subregion 115b.

It is an advantage of embodiments of the present invention that STI is used for defining the well contacts as this results in Hall sensors which are superior in terms of magnetic offset performance compared to Hall sensors which do not comprise well contact definition structures. Using STI may, however, result in an increased signal to noise ratio. This is resolved by providing the regions 112 of the second conductivity type between the sides of the shallow trench isolation regions 113 and the electrically conductive well 111 and by ensuring that the STI and the well contacts are in contact with each other. Even though an additional implant is required for providing the regions 112 of the second conductivity type, the advantage of the reduced noise level of the output signal allows to use Hall sensors wherein the well contacts are defined by STI. This is especially advantageous for vertical Hall sensors wherein STI is used for the contact definition.

A semiconductor chip 100 comprising Hall sensors in accordance with embodiments of the present invention may by used for 3D sensing. It is thereby advantageous that an integrated magnetic concentrator (IMC) is not required. It is, moreover, advantageous that a larger product design window can be obtained as there is no IMC saturation field.

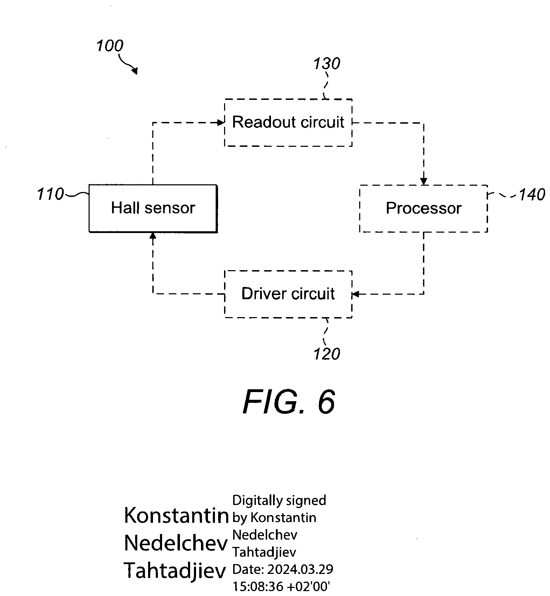

A semiconductor chip 100 according to embodiments of the present invention may comprise a driver circuit 120 for biasing a first pair of the well contacts 114 of the at least one Hall sensor 110. A block diagram of such an exemplary semiconductor chip, in accordance with embodiments of the present invention, is illustrated in FIG. 6. The semiconductor chip 100, furthermore, may comprise a readout circuit 130 for reading an output signal between a second pair of the well contacts 114 while biasing the first pair of the well contacts. This output signal is indicative for a component of the magnetic field. The semiconductor chip 100 additionally may comprise a processor 140 for processing the output signal and/or for controlling the driver circuit 120. The output signal may be processed such that a value is obtained which is indicative for the strength of the measured magnetic field component. Alternatively, the processing may for example be done to obtain the strength and direction of the magnetic field, or to obtain the position of a magnet, or to obtain the position of the rotor of a motor.

## Claims

1. A semiconductor chip (100) comprising at least one Hall sensor (110), the at least one Hall sensor (110) comprising:
- an electrically conductive well (111) with a first conductivity type in a semiconductor substrate,
- a plurality of well contacts (114) arranged at a surface of the electrically conductive well (111), and having the first conductivity type,
- a plurality of shallow trench isolation regions (113) which are delimiting the well contacts (114) at the surface of the electrically conductive well (111),
- wherein an implant (112) of a second conductivity type, opposite to the first conductivity type, is present on sides of the shallow trench isolation regions (113) such that the Hall sensor (110) comprises a depletion region comprising:
- a first subregion (115a) between the implant (112) and the electrically conductive well (111), and
- a second subregion (115b) between the implant (112) and the well contact (114).

2. A semiconductor chip (100) according to claim 1 wherein the implant has a thickness smaller than 5 µm.

3. A semiconductor chip (100) according to any of the previous claims wherein the first conductivity type is n-type and the second conductivity type is p-type.

4. A semiconductor chip (100) according to any of the claims 1 or 2 wherein the first conductivity type is p-type and the second conductivity type is n-type.

5. A semiconductor chip (100) according to any of the previous claims wherein the implant (112) has a dopant concentration of at least 1e15cm-3.

6. A semiconductor chip (100) according to any of the previous claims wherein the shallow trench isolation regions (113) have a depth of at least 100 nm.

7. A semiconductor chip (100) according to any of the previous claims wherein the electrically conductive well (111) has a dopant concentration of at least 1e15cm-3.

8. A semiconductor chip (100) according to any of the previous claims wherein the well contacts (114) have a dopant concentration of at least 1e18cm-3.

9. A semiconductor chip (100) according to any of the previous claims, the semiconductor chip (100) comprising a driver circuit (120) for biasing a pair of the well contacts (114) of the at least one Hall sensor (110) and a readout circuit (130) for reading an output signal between another pair of the well contacts (114) of the at least one Hall sensor (110).

10. A semiconductor chip (100) according to claim 9, the semiconductor chip (100) comprising a processor (140) for processing the output signal and/or for controlling the driver circuit (120).

11. A semiconductor chip (100) according to any of the previous claims, the semiconductor chip comprising at least three Hall sensors (110) sensitive to three linear independent directions.

12. A semiconductor chip (100) according to any of the previous claims wherein the at least one Hall sensor (110) is a horizontal Hall sensor or a vertical Hall sensor or wherein the semiconductor chip both comprises a horizontal and a vertical Hall sensor.

13. A method (200) for manufacturing a semiconductor chip (100) according to any of the previous claims, the method comprising:
- providing (210) a semiconductor substrate,
- doping (220) the semiconductor substrate with a dopant of a first conductivity type to obtain an electrically conductive well (111) in the semiconductor substrate,
- providing (230) shallow trench isolation regions (113) in the electrically conductive well (111),
- doping (240) the semiconductor substrate with a dopant of a second conductivity type, opposite to the first conductivity type, to provide implants (112) on sides of the shallow trench isolation regions (113)
- doping (250) regions between the shallow trench isolation regions (113) with a dopant with the first conductivity type,
wherein the implants are provided such that the Hall sensor (110) comprises a depletion region comprising: a first subregion (115a) between the implant (112) and the electrically conductive well (111), and a second subregion (115b) between the implant (112) and the well contact (114).
